(19) Europäisches Patentamt
European Patent Office
Office européen des brevets

(11) **EP 2 370 617 B1**

(12) # EUROPÄISCHE PATENTSCHRIFT

(45) Veröffentlichungstag und Bekanntmachung des Hinweises auf die Patenterteilung:
**26.12.2012 Patentblatt 2012/52**

(21) Anmeldenummer: **09749132.8**

(22) Anmeldetag: **12.11.2009**

(51) Int Cl.:
**C30B 11/00** (2006.01)    **C30B 15/30** (2006.01)

(86) Internationale Anmeldenummer:
**PCT/EP2009/065063**

(87) Internationale Veröffentlichungsnummer:
**WO 2010/060802 (03.06.2010 Gazette 2010/22)**

(54) **VERFAHREN ZUM ERSTARREN EINER NICHTMETALL-SCHMELZE**

METHOD FOR FREEZING A NONMETAL MELT

PROCÉDÉ DE SOLIDIFICATION D'UNE MATIÈRE NON MÉTALLIQUE EN FUSION

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **28.11.2008 DE 102008059521**

(43) Veröffentlichungstag der Anmeldung:
**05.10.2011 Patentblatt 2011/40**

(73) Patentinhaber: **Forschungsverbund Berlin e.V.
12489 Berlin (DE)**

(72) Erfinder:
• **BÜLLESFELD, Frank
60314 Frankfurt (DE)**
• **SAHR, Uwe
90411 Nürnberg (DE)**
• **MILLER, Wolfram
12161 Berlin (DE)**
• **RUDOLPH, Peter
12529 Schönefeld (DE)**
• **REHSE, Uwe
16515 Oranienburg (DE)**
• **DROPKA, Natascha
12167 Berlin (DE)**

(74) Vertreter: **Gulde Hengelhaupt Ziebig & Schneider
Patentanwälte - Rechtsanwälte
Wallstraße 58/59
10179 Berlin (DE)**

(56) Entgegenhaltungen:
**EP-A1- 1 225 255**

• **KRAUZE A ET AL: "Numerical 2D modelling of turbulent melt flow in CZ system with dynamic magnetic fields" JOURNAL OF CRYSTAL GROWTH, Bd. 266, Nr. 1-3, 15. Mai 2004 (2004-05-15), Seiten 40-47, XP004505874 ELSEVIER, AMSTERDAM [NL] ISSN: 0022-0248 DOI: 10.1016/J.JCRYSGRO.2004.02.028**
• **RUDOLPH P ET AL: "A new method to grow III-V crystals from melt in travelling magnetic fields" 20TH INTERNATIONAL CONFERENCE ON INDIUM PHOSPHIDE AND RELATED MATERIALS (IPRM) VERSAILLES [FR] 25 - 29 MAY 2008, 25. Mai 2008 (2008-05-25), Seiten 1-3, XP031372652 IEEE, PISCATAWAY, NJ [US] DOI: 10.1109/ICIPRM.2008.4702896 ISBN: 978-1-4244-2258-6**

## Beschreibung

Die Erfindung betrifft ein Verfahren nach dem Oberbegriff des nebengeordneten Anspruchs. Insbesondere betrifft die Erfindung ein Verfahren zum gerichteten Erstarren einer Silizium-Schmelze.

In der Solarindustrie ist es üblich, Siliziumkristalle zur Herstellung von Solarzellen durch gerichtete Erstarrung herzustellen. Dazu wird das Ausgangsmaterial in granularer Form in einem Quarzglastiegel geschmolzen, um dann unter Aufbringung eines vertikalen Temperaturgradienten gerichtet zu erstarren. Die so erhaltenen Blöcke, sog. Ingots, werden zu dünnen Siliziumscheiben zersägt, die in weiteren Verfahrenschritten zu Solarzellen verarbeitet werden können. Der Schmelztiegel ist üblicherweise mit einer Schicht aus $Si_3N_4$ überzogen (siehe z.B. Artikel "Transition metals in photovoltaic-grade ingot-cast multicrystalline silicon : Assessing the role of impurities in silicon nitride crucible lining material" von T. Buonassis et al, veröffentlicht im Journal of Crystal Growth, 287 (2006), Seiten 402-407) die die Wandung des Tiegels gegen die aggressive Silizium-Schmelze schützt und auch das Herauslösen des Ingots aus dem Tiegel nach dem Abkühlen erleichtert. Die in der Schmelze vorherrschende konvektive Strömung wird im wesentlichen durch das Temperaturfeld bestimmt. Jedoch bestehen Möglichkeiten zur Beeinflussung der Strömungen insbesondere durch Anwendung von stationären oder instationären Magnetfeldern. Es ist an sich bekannt, ein Wandermagnetfeld zu erzeugen, welches die Möglichkeit bietet, mit relativ schwachen Feldstärken einen starken Einfluß auf die Strömungen in der Schmelze zu nehmen. Eine Übersicht zur Anwendung von statischen und nichtstatischen Magnetfeldern in der Kristallzüchtung ist in dem Artikel "Travelling magnetic fields applied to bulk crystal growth from the melt: The step from basic research to industrial scale" von P. Rudolph, veröffentlicht im Journal of Crystal Growth, 310 (2008), Seiten 1298-1306.

Aus der Patentanmeldung DE 35 27 387 A1 ist ein Verfahren zum elektromagnetischen Rühren metallischer Schmelzen bekannt, bei dem an dem Schmelztiegel befindliche Induktoren mit Drehströmen verschiedener Frequenzen gespeist werden, um magnetische Felder zu erzeugen, die sich als überlagernde Drehfelder in azimutaler Richtung darstellen. Die dortige Anordnung ist in Form einer Statorwicklung, wie sie vom Drehstrom-Motor her bekannt ist, vorgesehen, um in der horizontalen Ebene rotierende Drehfelder auszuprägen. Diese Maßnahmen eignen sich zwar für das elektromagnetische Rühren magnetischer Schmelzen, sie sind jedoch für ein Erstarren von Nichtmetall-Schmelzen, das insbesondere in vertikaler Richtung erfolgen soll, eher ungeeignet.

Aus der Patentanmeldung DE 10 2006 020 234 A1 ist eine Vorrichtung in Gestalt eines Ofens sowie ein Verfahren zum Erstarren einer Nichtmetall-Schmelze bekannt. Dort wird ein Wanderfeld mit drei Leitungsschleifen erzeugt, die mit phasenverschobenen Drehströmen gespeist werden. Die Leitungsschleifen bzw. Induktoren sind so angeordnet, dass sie im wesentlichen ein vertikal verlaufendes Wanderfeld erzeugen. Jedoch bildet ein so erzeugtes Wanderfeld, insbesondere am Randbereich des Schmelztiegels, eine starke Lorentzkraftdichte aus. Dies hat eine hohe Geschwindigkeit der Schmelze am Tiegelrand zur Folge, die sich wiederum nachteilig, insbesondere erodierend, auf die Innenbeschichtung des Schmelztiegels auswirkt.

In der Patentanmeldung DE 103 49 339 A1 wird eine Kristallzüchtungsanlage mit einem Heizer beschrieben, der gleichzeitig einen Induktor zur Erzeugung eines Wandermagnetfeldes darstellt. Dabei wird der Induktor an eine Stromquelle für dreiphasigen Drehstrom angeschlossen und so ein Wandermagnetfeld mit nur einer Frequenz erzeugt.

In der Patentanmeldung DE 101 02 126 A1 ist ein Verfahren zur Herstellung von Kristallen durch Ziehen aus der Schmelze unter Verwendung eines Wandermagnetfeldes einer Frequenz beschrieben.

In der Patentanmeldung DE 10 2007 020 239 A1 wird eine Vorrichtung zur Herstellung von Kristallen aus elektrisch leitenden Schmelzen beschrieben, die eine Mehrspulenanordnung als Heizeinrichtung enthält. Die Mehrspulenanordnung wird jedoch nur mit Wechselströmen einer Frequenz betrieben. Aufgabe der Erfindung ist es demnach, die oben genannten Nachteile in vorteilhafter Weise zu überwinden. Insbesondere soll ein Verfahren der eingangs genannten Art derart verbessert werden, dass die Strömungsverteilung und das Erstarren einer Nichtmetall-Schmelze kontrolliert durchgeführt werden können.

Gelöst wird die Aufgabe durch ein Verfahren mit den Merkmalen des Anspruchs 1.

Demnach wird ein Verfahren zum Erstarren einer Nichtmetall-Schmelze vorgeschlagen, bei dem mittels einer Vielzahl von Induktoren magnetische Felder erzeugt werden, wobei die Induktoren mit einem ersten Satz phasenverschobener und eine erste Frequenz aufweisender Wechselströme versorgt werden, so dass durch Überlagerung von magnetischen Feldern ein erstes Wanderfeld in der Schmelze erzeugt wird, und mit mindestens einem zweiten Satz phasenverschobener und eine zweite Frequenz aufweisender Wechselströme versorgt werden, wobei durch Überlagerung der mit der zweiten Frequenz erzeugten magnetischen Felder ein zweites Wanderfeld in der Schmelze erzeugt wird, das dem ersten Wanderfeld entgegen gerichtet ist, und wobei die mindestens zwei erzeugten Wanderfelder gegensinnig die Schmelze vorzugsweise in vertikaler Richtung durchlaufen.

Dazu kann eine Vielzahl von Induktoren zur Erzeugung von sich überlagernden magnetischen Feldern vorgesehen werden, wobei die Induktoren mit mindestens zwei Sätzen phasenverschobener Wechselströme versorgt werden, die verschiedene Frequenzen aufweisen, um ein erstes Wanderfeld und mindestens ein zweites Wanderfeld in der Schmelze zu erzeugen, das dem ersten Wanderfeld entgegengerichtet ist, wobei die Induktoren an dem Tiegel in einer sich vertikal erstreckenden Anordnung ausgeführt sind, so dass die erzeugten Wanderfelder die Schmelze gegensinnig in vertikaler Richtung durchlaufen und die radialen Feldanteile sich gegenseitig aufheben.

Durch diese Merkmalskombination bilden sich zwei entgegengesetzte Wanderfelder in vertikaler Richtung aus, was dazu führt, dass im Randbereich eine Lorentzkraftdichte vorherrscht, die zu einer geringeren Geschwindigkeit als im Volumenbereich der Schmelze führt. Durch Einstellung der Parameter, insbesondere durch Wahl des Verhältnisses beider Frequenzen, kann ein ausreichender Abstand zur Innenwand des Schmelztiegels definiert werden, an dem die maximale Lorentzkraftdichte vorherrscht. Nach diesem Prinzip können auch mehr als zwei sich in vertikaler Richtung überlagernder Wanderfelder erzeugt werden.

Vorzugsweise sind die Induktoren z.B. als Spulen, also als in horizontaler Richtung umlaufende Wicklungen, ausgebildet, wobei die Wicklungen in vertikaler Richtung separat übereinander oder auch in vertikaler Richtung ineinander verschachtelt angeordnet sein können. In diesem Zusammenhang können sowohl der Tiegel wie auch die Windungen und der Spuleninnenbereich bzw. -durchmesser einen rechteckförmigen Querschnitt aufweisen.

Vorzugsweise können die Induktoren auch mit einem aus Wechselstrom- und Gleichstromanteilen bestehenden Heizstrom zum Heizen der Schmelze versorgt werden. In diesem Zusammenhang ist es für die effektive Erzeugung der Wanderfelder notwenig, dass der Heizstrom einen Wechselstromanteil von mindestens einem vorgebbaren Prozentsatz, insbesondere von mindestens 10%, aufweist. Vorteilhaft ist es auch, wenn die erste Frequenz und die zweite Frequenz sich höchstens um einen vorgebbaren Faktor, insbesondere um den Faktor 2-40, voneinander unterscheiden. Das Verhältnis der Frequenzen bzw. der Faktor kann prozessabhängig, z.B. in Abhängigkeit des Kristallisationsgrades eingestellt werden.

Bevorzugt können auch der erste und/oder zweite Satz der phasenverschobenen Wechselströme mehrere zueinander nicht-äquidistant phasenverschobene Wechselströme darstellen.

Die Erfindung ist insbesondere geeignet zum Einsatz in einen Schmelzofen bzw. Kessel für Silizium-Schmelzen. In diesem Zusammenhang kann der Schmelztiegel mit einer Schutzschicht an der Innenwand, insbesondere einer Schicht aus $Si_3N_4$, überzogen und als Quarzglastiegel ausgebildet sein.

Bei dem erfindungsgemäßen Verfahren können bevorzugte Parameter so eingestellt werden, dass die erste Frequenz und die zweite Frequenz sowie eine erste Eindringtiefe und eine zweite Eindringtiefe für die jeweils erzeugten magnetischen Felder folgende Gleichung erfüllen:

$$D < \frac{ED1 \bullet ED2 \bullet \ln(x)}{ED2 - ED1} \quad ,$$

wobei

$$x = \frac{FD1 \bullet ED2}{FD2 \bullet ED1}$$

ist.

Die Eindringtiefe ED ist der Abstand D vom Tiegelrand, bei dem die Lorentzkraftdichte FD auf 1/e*FD abgefallen ist.

Nachfolgend wird die Erfindung und die sich daraus ergebenden Vorteile im Detail anhand von Ausführungsbeispielen und unter Bezugnahme auf die beiliegenden Zeichnungen beschrieben, wobei:

Figur 1    schematisch den Aufbau einer für die Durchführung des erfindungsgemäßen Verfahrens geeigneten Vorrichtung zum Erstarren einer Nicht-Metallschmelze darstellt;

Figur 2    ein Funktionsdiagramm mit dem Verlauf von Lorentzkraftdichten in Abhängigkeit vom Abstand zur Schmelztiegelwand darstellt; und

Figur 3    ein Funktionsdiagramm mit dem Verlauf von Lorentzkraftdichten gemäß dem erfindungsgemäßen Verfahren darstellt.

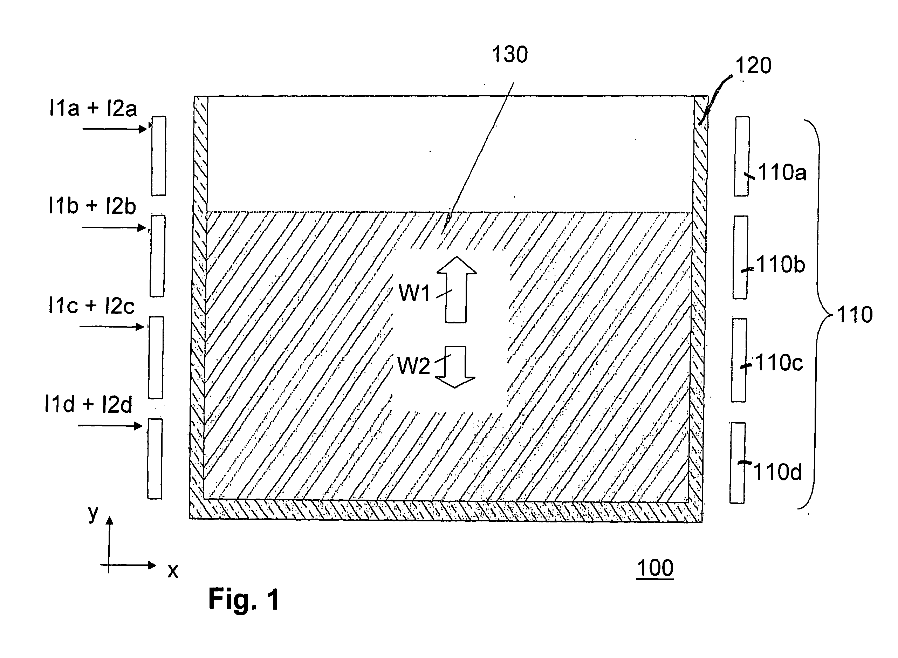

Die Figur 1 zeigt in schematischer Darstellung eine Vorrichtung 100 zum Erstarren einer Nicht-Metallschmelze 130, die sich in einem Tiegel 120 befindet. Die Schmelze ist beispielsweise eine Silizium-Schmelze und der Tiegel 120 stellt einen, hier beispielsweise rechteckigen, Quarzglastiegel dar. Von außen sind mehrere Induktoren 110 um den Tiegel 120 angeordnet, um durch Einspeisung von Wechselströmen magnetische Felder in die Schmelze 130 zu induzieren, so dass mindestens zwei überlagernde Wanderfelder W1 und W2 sich entgegengesetzt zueinander in vertikaler Richtung Y bewegen. Beispielsweise sind vier Induktoren 110a bis 110d in vertikaler Richtung Y übereinanderliegend angeordnet und werden mit einem ersten Satz phasenverschobener Wechselströme I1a - I1d sowie mit einem zweiten Satz phasenverschobener Wechselströme I2a - I2d gespeist. Der erste Satz phasenverschobener Wechselströme wird mit einer ersten Frequenz f1 eingespeist, die beispielsweise 200 Hz beträgt. Der zweite Satz phasenverschobener Wechselströme wird mit einer zweiten Frequenz f2 eingespeist, die beispielsweise 20 Hz beträgt.

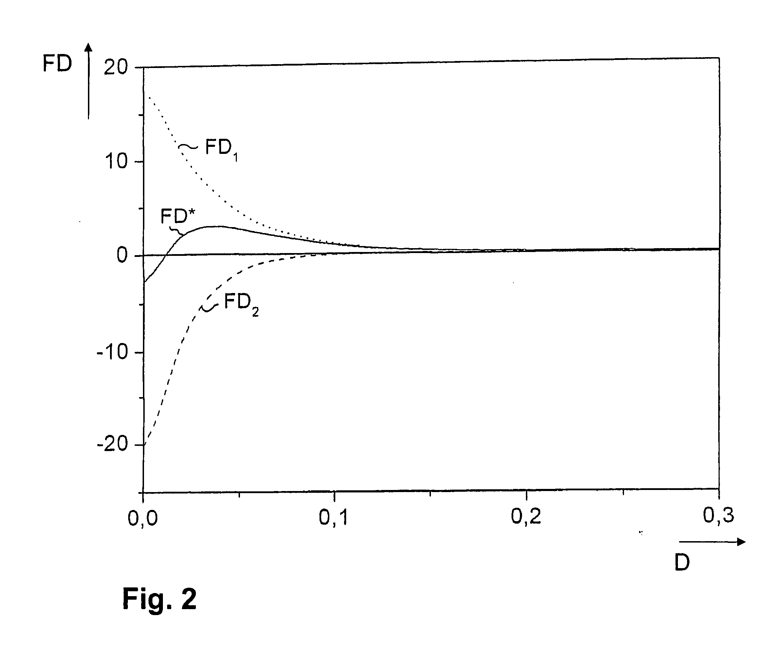

Wie anhand der Figur 2 erläutert wird, ergibt sich durch Überlagerung der so erzeugten Wechselfelder W1 und W2 eine entsprechende Überlagerung von Lorentzkraftdichten FD1 mit FD2 zu einer resultierenden Lorentzkraftdichte FD*. Die erste Lorentzkraftdichte FD1 wird über die Einspeisung des ersten Satzes von Wechselströmen I1a - I1d erzeugt, wobei im Randbereich des Tiegels, d. h. D = 0, sich eine relativ hohe Lorentzkraftdichte einstellt. Durch Einspeisung des zweiten Satzes phasenverschobener Wechselströme I2a - I2d ergibt sich ein Verlauf der Lorentzkraftdichte FD2, der im Randbereich, d.h. D = 0, einen negativen Wert aufweist. Durch Überlagerung von FD1 und FD2 ergibt sich somit ein Lorentzkraftdichte-Verlauf FD*, der im Randbereich einen abgesenkten Wert aufweist. Durch Einstellung der Parameter, insbesondere der Frequenzen f1 und f2 kann erfindungsgemäß erreicht werden, dass im Randbereich die resultierenden Strömungsgeschwindigkeiten sehr gering und idealerweise zu Null wird.

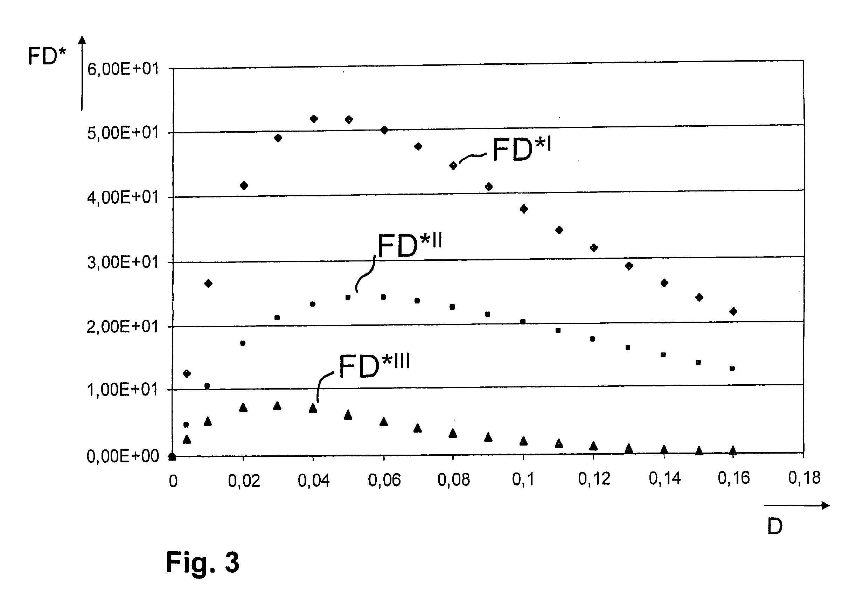

Die Figur 3 zeigt den Verlauf der resultierenden Lorentzkraftdichte FD* bei verschieden eingestellten Parametern. Die obere Kurve FD*' zeigt den Verlauf der Lorentzkraftdichte, wenn die erste Frequenz f1 zu 20 Hz gewählt wird und das entsprechende Wanderfeld W1 sich von unten nach oben erstreckt und wenn die zweite Frequenz f2 zu 400 Hz gewählt wird, wobei sich das entsprechende Wanderfeld W2 von oben nach unten erstreckt. Die zweite Kurve FD*'' ergibt sich, wenn f1 gleich 20 Hz beträgt und W1 von unten nach oben verläuft sowie wenn f2 gleich 200 Hz ist und W2 von oben nach unten verläuft. Die dritte Kurve FD*''' ergibt sich, wenn f1 gleich 200 Hz beträgt und von oben nach unten verläuft und wenn f2 gleich 400 Hz beträgt und von unten nach oben verläuft.

Wie sich aus einem Vergleich der dargestellten Kurvenverläufe ergibt, ist in allen drei dargestellten Beispielen die resultierende Lorentzkraftdichte FD* im Randbereich, d.h. D = 0, deutlich abgesenkt und beträgt in etwa 0 N/m$^3$. Durch die Wahl des Verhältnisses f1 zu f2 verschiebt sich das Maximum der Lorentzkraftdichte in das Innere der Schmelze hinein, d.h. D > 0. Die zweite Kurve FD*'' weist dabei eine maximale Lorentzkraftdichte im Bereich D = 0,06 auf. Bei den anderen Kurvenverläufen liegt das Maximum bei einem geringeren Abstand. Der Kurvenverlauf FD*' weist ein Maximum im Bereich von D = 0,04 auf und der Kurvenverlauf FD*''' weist ein Maximum im Bereich D = 0,025 auf. Demnach kann das Maximum der Lorentzkraftdichte besonders weit ins Innere der Schmelze hinein verschoben werden, wenn eine der beiden Frequenzen, hier f1, relativ gering ist und beispielsweise 20 Hz beträgt und wenn die andere Frequenz, hier f2, nicht sehr viel größer ist, also z.B. nicht größer als das 40-fache von f1 ist.

Durch die Wahl der Frequenzen f1 und f2 kann erreicht werden, dass die Strömungsgeschwindigkeit am Tiegelrand recht klein ist und nicht größer als 0 bis 1 cm/sec. beträgt. Auch kann erreicht werden, dass die Strömungsgeschwindigkeit zum inneren der Schmelze hin, etwa im Abstand D = 1 cm, größer als 0,01 bis 2 cm/sec. liegt. Der Verlauf der Lorentzkraftdichte und der sich daraus ergebenden Strömungsgeschwindigkeit bzw. Beeinflussung der Konvektion kann insbesondere durch die Parametrisierung der Frequenzen aus Ausbreitungsrichtungen, Phasenverschiebungen, Amplituden und Geometrieen der Induktoren optimal eingestellt werden. Für die Erzeugung der Wanderfelder müssen die Induktoren mit relativ hohen Strömen von beispielsweise 200 A gespeist werden, wodurch wegen Ohmscher Verluste eine Erwärmung der Induktoren entsteht. Anstatt diese Wärme über Kühlmaßnahmen abzuleiten, kann es auch vorgesehen sein, dass die Induktoren gleichzeitig als Heizelemente zur kontrollierten Erhitzung der Schmelze eingesetzt werden. Hierbei ist es von Vorteil, wenn zusätzlich zu den Wechselströmen, welche die Wanderfelder erzeugen, auch noch ein Heizstrom eingespeist wird, der nur Gleichstrom aufweist. Das Verhältnis von Wechselstromanteilen zu Gleichstromanteilen kann prozessbedingt eingestellt werden.

Zur Erzeugung der beschriebenen Funktionsverläufe der Lorentzkraftdichten (siehe Fig. 2 und 3) ist vor allem die Parametrisierung der Wechselströme I1a - I1d sowie I2a - I2d erforderlich. Dabei hat sich gezeigt, dass zur Erzeugung eines Maximums der Lorentzkraftdichte im Inneren der Schmelze folgende Bedingung erfüllt sein muss:

$$FD1/FD2 > ED1/ED2 \text{ und } ED2 > ED1.$$

Dabei bedeutet FD1 bzw. FD2 der Betrag der Lorentzkraft an der Tiegelwand sowie ED1 bzw. ED2 die Eindringtiefe des Magnetfeldes.

Der Abstand der maximal auftretenden Lorentzkraft von der Tiegelwand ergibt sich dabei aus folgender Beziehung:

$$D* < ED1 \cdot ED2 / (ED2 - ED1) \cdot LN (FD1 \cdot FD2 / FD2 \cdot ED1),$$

wobei D* den Mindestabstand von der Wand darstellt.

Für den Einsatz der Erfindung beim Erschmelzen und Erstarren von Solarsilizium in einem Quarzglastiegel hat es sich als besonders vorteilhaft erwiesen, wenn das Maximum des Kraftfeldes einen Abstand von etwa 0,1 cm bis 40 cm von der Tiegelwand hat, d.h. D = 0,1 bis 40 cm.

Bei der Bestromung der Induktoren bzw. Wicklungen kann auch vorgesehen sein, dass die Phasenverschiebung zwischen den einzelnen Wicklungen nicht-äquidistant ist. Denn die vertikale Anordnung der Induktoren stellt im wesentlichen einen Teilabschnitt eines sich in vertikaler Richtung erstreckenden Linearmodus dar, der abschnittsweise mit verschiedenartig phasenverschobenen Strömen bestromt werden kann.

Anhand der nachfolgenden Tabelle 1 sind für ein erstes Ausführungsbeispiel die Parameter angegeben.

**Tabelle 1**

| Wicklung | 110a | 110b | 110c | 110d |
|---|---|---|---|---|
| f1 in Hz | 200 | 200 | 200 | 200 |
| f2 in Hz | 20 | 20 | 20 | 20 |
| FD1 max. rel. Einheiten | 0,1 | 0,1 | 0,1 | 0,1 |
| FD2 max. rel. Einheiten | 0,053 | 0,053 | 0,053 | 0,053 |
| Phasenverschiebung von I1a-d | 0 | 90 | 180 | 270 |
| Phasenverschiebung von I2a-d | 0 | -90 | -180 | -270 |

Die Angaben von FD1 und FD2 sind relative Angaben, die sich auf eine Bezugsgröße von X N/m3 beziehen. Das mit den angegebenen Parametern hergestellte Silizium und die daraus erzeugten Solarzellen zeigen einen deutlich höheren Wirkungsgrad als übliche Solarzellen. Außerdem läßt sich der Ingot leichter von dem Quarzglastiegel lösen. Es kommt zu deutlich weniger Klebestellen des Ingots an dem Quarzglastiegel als dies herkömmlicher Weise der Fall ist. Zusätzlich wird die Schmelze deutlich weniger mit Komponenten aus dem Tiegelmaterial oder der Beschichtung verunreinigt. Der Ingot enthält daher weniger Ausscheidungen von Fremdphasen.

Für ein weiteres Beispiel wird in der Tabelle 2 die Parametrisierung wie folgt angegeben:

**Tabelle 2**

| Wicklung | 110a | 110b | 110c | 110d |
|---|---|---|---|---|
| f1 in Hz | 100 | 100 | 100 | 100 |
| f2 in Hz | 20 | 20 | 20 | 20 |
| I1 (a-d) in A | 200 | 200 | 200 | 200 |
| I2 (a-d) in A | 200 | 200 | 200 | 200 |
| FD1 max. rel. Einheiten | 20 | 20 | 20 | 20 |
| FD2 max. rel. Einheiten | 17,5 | 17,5 | 17,5 | 17,5 |
| Phasenverschiebung von I1 (a-d) | 0 | 90 | 180 | 270 |
| Phasenverschiebung von I2 (a-d) | 0 | -120 | -240 | -360 |

Die sich hieraus ergebende Lorentzkraftdichte ist in der Figur 2 dargestellt.

Bei den erfindungsgemäß erzeugten Magnetfeldern nimmt also die resultierende Lorentzkraftdichte vom Rand der Schmelze her zu bis zu einem Maximum, das sich in einem Abstand D* von dem Randbereich befindet. Der Verlauf der Lorentzkraftdichte und die Lage des Maximums kann insbesondere durch Wahl des Verhältnisses zwischen der ersten Frequenz f1 und der zweiten Frequenz f2 eingestellt werden. Die erfindungsgemäße Anordnung ist auch geeignet, um bei rechteckförmigen bzw. quadratischen Schmelztiegeln eingesetzt zu werden. Die Wicklungen können in diesem Fall ebenfalls rechteckförmig am Rande des Tiegels verlaufen, ohne dass hierdurch die Funktionsweise der Magnetfelderzeugung nachteilig beeinflusst wird. Die Anordnung der Induktoren in vertikaler Richtung kann auch verschachtelt ineinander gestaltet sein. Vorzugsweise wird ein Satz von Induktoren eingesetzt, der mit beiden Frequenzen bestromt wird. Alternativ kann auch für jede Frequenz ein eigener Satz von Induktoren vorgesehen werden. Außerdem können die Induktoren auch als Heizer eingesetzt werden. Dazu wird auch ein Gleichstrom eingespeist, wobei der Wechselstromanteil mit f1 und/oder f2 mindestens 10% beträgt. Insgesamt ergibt sich eine sehr effektive Vorrichtung zum Erstarren von Nichtmetall-Schmelzen, insbesondere von Silizium-Schmelzen, wobei ein kontrolliertes vertikales Erstarren der Schmelze ermöglicht wird.

**Bezugszeichenliste**

| | |
|---|---|
| 100 | Vorrichtung (hier: Schmelzofen) zur Durchführung des Verfahrens |
| 110 | Induktoren (horizontal verlaufende Wicklungen) |
| 110a - 100d | Wicklungen der Induktoren |
| 120 | Tiegel, Hier Quarzglastiegel mit Innenbeschichtung |
| 130 | Schmelze, hier Silizium-Schmelze |
| I1a- I1d | erster Satz phasenverschobner Wechselströme |
| I2a- I2d | erster Satz phasenverschobner Wechselströme |
| W1, W2 | erstes bzw. zweites Wandlerfeld (gegenfäufig) |
| FD | Lorentzkraftdichte (in N/m$^3$) |
| FD1, FD2 | Lorentzkraftdichte aufgrund der einzelnen Wechselfelder |
| FD* | resultierende Lorentzkraftdichte (durch Überlagerung); FD*', FD*", FD*'" verschiedene Verläufe |
| D | Abstand von Innenwand des Tiegels (in m) |
| ED | Eindringtiefe des Magnetfeldes |

**Patentansprüche**

1. Verfahren zum Erstarren einer Nichtmetall-Schmelze (130), die sich in einem Tiegel (120) befindet, indem mittels einer Vielzahl von Induktoren (100) magnetischen Felder erzeugt werden, wobei die Induktoren (100) mit einem ersten Satz phasenverschobener und eine erste Frequenz (f1) aufweisender Wechselströme (I1a, I1b, I1c, I1d) gespeist werden, so dass durch Überlagerung von magnetischen Feldern ein erstes Wanderfeld (W1) in der Schmelze (130) erzeugt wird, und mit mindestens einem zweiten Satz phasenverschobener und eine zweite Frequenz (f2) aufweisender Wechselströme (I2a, I2b, I2c, I2d) versorgt werden,
**dadurch gekennzeichnet, dass**
durch Überlagerung der mit der zweiten Frequenz (f2) erzeugten magnetischen Feldern ein zweites Wanderfeld (W2) in der Schmelze (130) erzeugt wird, das dem ersten Wanderfeld (W1) entgegen gerichtet ist, wobei die zwei erzeugten Wanderfelder (W1, W2) die Schmelze (130) in einer im wesentlichen vertikalen Richtung (Y) durchlaufen.

2. Verfahren nach Anspruch 1, **dadurch gekennzeichnet, dass** die Induktoren (100) an dem Tiegel (120) in einer sich vertikal erstreckenden Anordnung angeordnet werden, so dass die zwei erzeugten Wanderfelder (W1, W2) sich in der Schmelze (130) im wesentlichen in vertikaler Richtung (Y) bewegen.

3. Verfahren nach Anspruch 2, **dadurch gekennzeichnet, dass** ein Satz von Induktoren (100) an dem Tiegel (120) angeordnet wird, der mit den die erste und die zweite Frequenz (f1, f2) aufweisenden Wechselströmen (I1a, I1b, I1c, I1d; I2a, I2b, I2c, I2d) gespeist wird.

4. Verfahren nach Anspruch 2, **dadurch gekennzeichnet, dass** zwei Sätze von Induktoren an dem Tiegel angeordnet werden, von denen der eine Satz einer mit den die erste Frequenz aufweisenden Wechselströmen gespeist wird und der andere Satz mit den die zweite Frequenz aufweisenden Wechselströmen gespeist wird.

5. Verfahren nach einem der vorhergehenden Ansprüche, **dadurch gekennzeichnet, dass** mehr als zwei sich überlagernde und im wesentlichen in vertikaler Richtung bewegende Wanderfelder erzeugt werden.

6. Verfahren nach einem der vorhergehenden Ansprüche, **dadurch gekennzeichnet, dass** die Induktoren (100) auch mit einem aus Wechselstrom- und Gleichstomanteilen bestehenden Heizstrom (Ih) zum Heizen der Schmelze (130) versorgt werden.

7. Verfahren nach Anspruch 6, **dadurch gekennzeichnet, dass** der Heizstrom (Ih) einen Wechselstromanteil von mindestens einem vorgebbaren Prozentsatz, insbesondere von mindestens 10%, aufweist.

8. Verfahren nach Anspruch 6 oder 7, **dadurch gekennzeichnet, dass** der Wechselstromanteil die mindestens zwei Frequenzen (f1, f2) aufweist.

9. Verfahren nach einem der vorhergehenden Ansprüche, **dadurch gekennzeichnet, dass** die erste Frequenz (f1) und die zweite Frequenz (f2) sich höchstens um einen vorgebaren Faktor, insbesondere um einen Faktor von 2 bis 40, voneinander unterscheiden.

10. Verfahren nach einem der vorhergehenden Ansprüche, **dadurch gekennzeichnet, dass** der erste und/oder zweite Satz phasenverschobener Wechselströme mehrere zueinander nicht-äquidistant phasenverschobene Wechselströme aufweist.

11. Verfahren nach einem der vorhergehenden Ansprüche, **dadurch gekennzeichnet, dass** die erste Frequenz (f1) und die zweite Frequenz (f2) sowie eine erste Eindringtiefe (d1) und zweite Eindringtiefe (d2) für die jeweils durch die mit der ersten bzw. zweiten Frequenz (f1, f2) erzeugten magnetischen Felder folgende Gleichung erfüllen:

$$D < ED1 \cdot ED2 \cdot \cdot \ln(X) / (ED2 - ED1),$$

wobei
X = (FD1·ED2/FD2·ED1) ist und
D einen vorgebbaren Mindestabstand zur Innenwandung des Tiegels (120) für eine von den resultierenden Wanderfeldern (W1, W2) erzeugten Lorentzkraft angibt.

## Claims

1. A method for freezing of a nonmetal melt (130) located in a crucible (120)
   wherein a plurality of inductors (100) are generating magnetic fields, wherein the inductors (100) are being fed with a first set of phase-shifted alternating currents (I1a, I1b, I1e, I1d) of a first frequency (f1) such that in the melt (130) a first traveling magnetic field (W1) is generated by superimposing of magnetic fields, and wherein the inductors are being fed with a second set of phase-shifted alternating currents (I2a, I2b, I2c, 12d) of a second frequency (f2), **characterized In that**
   in the melt (130) a second traveling magnetic field (W2) is generated by superimposing of the magnetic fields which are being generated at the second frequency (f2), the second traveling magnetic field is oriented opposite to the first traveling field (W1), wherein both generated traveling fields (W1, W2) travel through the melt (130) essentially in a vertical direction (Y).

2. The method according to claim 1, **characterized in that** the inductors (100) are arranged to the crucible (120) in a vertically extended arrangement, such that both generated traveling fields (W1, W2) travel through the melt (130) essentially in a vertical direction (Y).

3. The method according to claim 2, **characterized in that** a set of inductors (100) is disposed at the crucible (120) which is fed with the alternating currents (I1a, I1b, I1e, I1d; I2a, I2b, I2c, 12d) of the first and second frequencies (f1, f2).

4. The method according to claim 2, **characterized in that** two sets of inductors are disposed at the crucible, of which one set is fed with alternating currents of the first frequency, and the other set is fed with alternating currents of the second frequency.

5. The method according to one of the preceding claims, **characterized in that** more than two traveling fields are generated which are superimposed and move substantially in the vertical direction.

6. The method according to one of the preceding claims, **characterized in that** the inductors (100) are also provided with a heating current (Ih) for heating the melt (130), wherein the heating current comprises alternating current and direct current components.

7. The method according to claim 6, **characterized in that** the heating current (Ih) comprises an alternating current component of at least one predetermined percentage, and in particular of at least 10%.

**8.** The method of claim 6 or 7, **characterized in that** the alternating current component comprises at least two frequencies (f1, f2).

**9.** The method according to one of the preceding claims, **characterized in that** the first frequency (f1) and the second frequency (f2) differ from each other at most about a predetermined factor, particularly about a factor of 2 to 40.

**10.** The method according to one of the preceding claims, **characterized in that** the first and/or second set of phase-shifted alternating currents comprises several mutually non-equidistant phase-shifted alternating currents.

**11.** The method according to one of the preceding claims, **characterized in that** the first frequency (f1) and the second frequency (f2), and a first depth (d1) and second depth (d2) for each of the magnetic fields being generated at the first or second frequency (f1, f2) meet the following equation:

$$D < ED1 \cdot ED2 \cdot \ln(X) / (ED2 - EDl),$$

wherein

$$X = (FD1 \cdot ED2 / FD2 \cdot ED1),$$

and wherein D is indicating a predetermined minimum distance from the inner wall of the crucible (120) for a Lorentz force being generated by the resulting traveling fields (W1, W2).

## Revendications

**1.** Une méthode de solidification d'une matière non métallique en fusion (130) située dans un creuset (120) dans lequel plusieurs inducteurs (100) génèrent des champs magnétiques, les inducteurs (100) étant alimentés par un premier ensemble de courant alternatifs à phases décalées (I1a, I1b, I1d) d'une première fréquence (f1) de telle manière qu'un premier champ magnétique en mouvement (W1) est généré au sein de la matière en fusion (130) par la superposition de champs magnétiques, et dans laquelle les inducteurs sont alimentés avec un second ensemble de courants alternatifs à phases décalées (I2a, I2b, I2c, I2d) d'une seconde fréquence (f2), **caractérisée en ce qu'**un second champ magnétique en mouvement (W2) est généré au sein de la matière en fusion (130) par la superposition des champs magnétiques qui sont générés à la seconde fréquence (f2), le second champ magnétique en mouvement étant orienté à l'opposé du premier champ magnétique en mouvement (W1), dans laquelle les deux champs magnétiques générés (W1, W2) sont en mouvement suivant une direction verticale (Y) au travers la matière en fusion (130),

**2.** La méthode selon la revendication 1, **caractérisée en ce que** les inducteurs (100) sont disposés relativement au creuset suivant une disposition verticale étendue, de telle manière que les deux champs en mouvement générés (W1, W2) sont en mouvement suivant une direction essentiellement verticale (Y) au travers la matière en fusion (130).

**3.** La méthode selon la revendication 2, **caractérisée en ce que** un ensemble d'inducteurs (100) est disposée au niveau du creuset (120), alimentés avec les courants alternatifs (I1a, I1b, I1e, I1d, I2a, I2b, I2c, I2d) des première et seconde fréquences (f1, f2).

**4.** La méthode selon la revendication 2, **caractérisée en ce que** deux ensembles d'inducteurs sont disposés au creuset, parmi lesquels un ensemble est alimenté avec des courants alternatifs de la première fréquence, et l'autre ensemble est alimenté avec des courants alternatifs de la seconde fréquence.

**5.** La méthode selon l'une des revendications précédentes, **caractérisée en ce que** plus de deux champs en mouvement sont générés et superposés et se déplacent substantiellement suivant une direction verticale.

**6.** La méthode selon l'une quelconque des revendications précédentes, **caractérisée en ce que** les inducteurs (100) sont également disposée avec un courant de chauffage (Ih) pour chauffer la matière en fusion (130), dans laquelle le courant de chauffage comporte un courant alternatif et des composantes de courant continu.

**7.** La méthode selon la revendication 6, **caractérisée en ce que** le courant de chauffage (Ih) comporte une composante de courant alternatif présentant au moins un pourcentage prédéterminé, et en particulier au moins égal à 10%.

**8.** La méthode selon la revendication 6 ou 7, **caractérisée en ce que** la composante de courant alternatif comporte au moins deux fréquences (f1, f2).

**9.** La méthode selon l'une quelconque des revendications précédentes, **caractérisée en ce que** la première fréquence (f1) et la seconde fréquence (f2) diffèrent l'une l'autre d'un facteur prédéterminé au plus, en particulier un facteur de 2 à 40 environ.

**10.** La méthode selon l'une quelconque des revendications précédentes, **caractérisée en ce que** les premier et/ou second ensembles de courants alternatifs à phases décalées comportent plusieurs courants alternatifs à phases décalées mutuellement non équidistants.

**11.** La méthode selon l'une quelconque des revendications précédentes, **caractérisée en ce que** la première fréquence (f1) et la seconde fréquence (f2), et une première profondeur (d1) et seconde profondeur (d2) pour chacun des champs magnétiques générés à la première ou seconde fréquence (f1, f2) se conforment à l'équation suivante:

$$D < ED1 . ED2 . \ln(X) / (ED2 - ED1),$$

dans laquelle
X = (FD1.ED2/ FD2.ED1), et dans laquelle
D indique une distance minimale prédéterminée depuis la paroi intérieure de creuset (120) pour une force de Lorentz générée par les champs en mouvement résultants (W1, W2).

**Fig. 1**

I1a + I2a

I1b + I2b

I1c + I2c

I1d + I2d

130

120

110a

110b

110

110c

110d

W1

W2

100

y

x

**Fig. 2**

**Fig. 3**

EP 2 370 617 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3527387 A1
- DE 102006020234 A1
- DE 10349339 A1
- DE 10102126 A1
- DE 102007020239 A1

**In der Beschreibung aufgeführte Nicht-Patentliteratur**

- **T. BUONASSIS et al.** Transition metals in photo-voltaic-grade ingot-cast multicrystalline silicon : Assessing the role of impurities in silicon nitride crucible lining material. *Journal of Crystal Growth,* 2006, vol. 287, 402-407
- **P. RUDOLPH.** Travelling magnetic fields applied to bulk crystal growth from the melt: The step from basic research to industrial scale. *Journal of Crystal Growth,* 2008, vol. 310, 1298-1306